# EUROPEAN PATENT APPLICATION

(11) **EP 3 301 204 A1**
(43) Date of publication of application: **04.04.2018**
(21) Application number: 17194135.4
(22) Date of filing: 29.09.2017
(51) Int. Cl.: C23C 16/458, C23C 16/46, C23C 16/48, C23C 16/52

(54) **A CHEMICAL VAPOUR DEPOSITION APPARATUS AND USE THEREOF**

(30) Priority: 30.09.2016 NL 2017558
(71) Applicant: Tempress IP B.V., 8171 MD Vaassen (NL)
(72) Inventor: Harris, Malcolm John, 8171 MD VAASSEN (NL); Venema, Peter Roelf, 8171 MD VAASSEN (NL); Renes, Marten Ronald, 8171 MD VAASSEN (NL); Luchies, Johannes Reinder Marc, 8171 MD VAASSEN (NL)
(74) Representative: Nollen, Maarten Dirk-Johan

(57) **Abstract**

The plasma-enhanced chemical vapour deposition (PECVD) apparatus comprises a tubular chamber (100) configured for a wafer boat (10) with substrates. The PECVD apparatus further comprises heating means (110) arranged at an outside of the chamber and configured for emitting heat by means of radiation, and a controller for controlling a state inside the chamber (100), including temperature and composition. Herein, the heating means (110) are configured for the provision of radiation according to a radially varying profile within the chamber, which radial heating profile comprises a first radial zone (I) and a second radial zone (II), and wherein a heat flux (F_{I}) in the first radial zone (I) is higher than the heat flux (F_{II}) in the second radial zone.

## Description

### FIELD OF THE INVENTION

The invention relates to a chemical vapour deposition apparatus comprising a tubular chamber of a horizontal type and provided with a bottom side and a top side and an axial direction, which tubular chamber is configured for arrangement of a susceptor carrying a plurality of substrates along the axial direction, which tubular chamber is provided with at least one inlet for a compound in a vapour phase into the chamber and with an entrance through which the susceptor may be entered and removed from the chamber, said axial direction being substantially parallel to a direction along which a susceptor is entered into and removed from the chamber. The chemical vapour deposition apparatus further comprises heating means arranged at an outside of the chamber and configured for emitting heat by means of radiation, and a controller for controlling a state inside the chamber, including temperature and composition.

The invention also relates to a system of a chemical vapour deposition apparatus and a susceptor for carrying a plurality of substrates.

The invention further relates to the use of such a chemical vapour deposition apparatus and such as a system.

### BACKGROUND OF THE INVENTION

Chemical vapour deposition apparatus are commonly used in the manufacture of semiconductor devices such as integrated circuits and solar cells. Herein, a compound in a vapour phase is introduced in the chamber and forms a thin solid film on a substrate by a chemical reaction. The chemical reactions of the - precursor - compounds may occur in the gas phase and on the substrate. Reactions c an be promoted or initiated by heat (thermal CVD), higher frequency radiation such as UV (photo-assisted CVD) or a plasma (plasma-enhanced CVD).

One of the requirements in chemical vapour deposition is that the temperature on the substrates is substantially uniform. Variations in temperature between the substrates may lead to lack of uniformity in depositions. Variations in temperature across a substrate may lead to stresses which can cause significant dislocation motion or slip. Thereto, heat is provided into the chamber by means of radiation. Thereto, use can be made of high intensity lamps, such as tungsten-halide lamps, RF induction coils, for instance. Often, the susceptor - also known as a wafer boat - first becomes warm and it, in turn, heats the substrate by a combination of conduction, radiation and convention heat transfer. However, one may further heat the substrate directly.

US4, 284,867 addresses some issues of non-uniformity in heating up substrates, particularly in the context of the production of solar cells in a tubular chamber. Herein, part of the energy induces the susceptor to heat the substrate and the remainder of the energy radiated from an radio-frequency (R.F.) induction coil is directed away from the chamber. Part of this heat is then redirected by means of a metallic infrared reflector having a concave configuration designed to focus the redirected energy on the chamber. The intention thereof is to prevent temperature differences across a single substrate in that the substrate is heated on both of its main surfaces simultaneously, i.e. by conduction and radiation from the susceptor to a first surface and by means of the redirected radiation on a second, opposed surface.

However, the solution in US4,284,867 appears based on a susceptor design for relatively small substrates, wherein the first surface is supported. Currently, substrates for solar cells have a size of 6 x 6 inch (15 x 15 cm). These substrates are not carried on one side. Rather, they are typically arranged in a rack, wherein merely some edges of the substrate are in direct contact with the susceptor. This particularly applies to susceptors or boats used in phase-enhanced chemical vapour deposition (PECVD). More particularly, in one embodiment of PECVD using a tubular reactor, the plasma is generated around the substrate by means of electrodes embodied as electrically conductive plates. These plates are part of the susceptor, and the substrate is present between a first and a second plate functioning as electrodes with opposed polarity. Due to the application of a voltage on the electrodes, the vapour compound is ionized around the substrate. The solution proposed in US4,284,867 therefore does not make much sense, as the arrangement of the first surface of the substrate relative to the susceptor is not different from the second surface.

US5,128,515 discloses a chemical vapour deposition apparatus of the type defined in the opening paragraph, wherein the heating means configured for the provision of radiation according to a angularly varying profile within the tubular chamber, which angular heating profile comprises a first and a second angular zone, and wherein a heat flux in the first angular zone is higher than in the second angular zone and wherein the first angular zone includes an area from the bottom side of the chamber. This is done, so as to compensate the amount of radiated heat loss that is shielded by the wafer boat and a fork used for inserting and removing of the wafer boat from the tubular chamber. The wafer boat is provided with a traditional boat form, including a bottom and external side walls, wherein the individual wafers can be positioned parallel to each other between opposed side walls.

However, currently common types of water boats for plasma-enhanced CVD have a completely different shape. They include vertically extending plates of electrically conductive material such as graphite, and a bottom side that is effectively open. Hence, the shielding of the bottom that was the reason for an angular heating profile, does not apply.

Still, in practice, it has been found that non-uniformities in layer thicknesses of deposited layers between individual substrates occur, and particularly when using accelerated ramp-up procedures, wherein the period for ramping up the temperature in the chamber is shortened, for instance to less than 30 minutes or even at most 15 minutes, so as to increase the through-put of a single apparatus.

### SUMMARY OF THE INVENTION

It is therefore a first object of the invention to provide an improved chemical vapour deposition apparatus with a tubular chamber that allows uniform heating of the substrates, and particularly in a PECVD tube reactor wherein the susceptor comprises conductive plates for the generation of the plasma.
It is a second object of the invention to provide a system of such improved chemical vapour deposition apparatus and a susceptor.
It is a further object of the invention to provide use of the chemical vapour deposition apparatus and the system therewith for the deposition of a layer on a substrate, particularly but not exclusively as part of solar cell manufacture.

In a first aspect, the invention provides a chemical vapour deposition apparatus comprising a tubular chamber provided with a bottom side and a top side and an axial direction, which chamber is configured for arrangement of a susceptor carrying a plurality of substrates, which chamber is provided with at least one inlet for a compound in a vapour phase into the tubular chamber and with an entrance through which the susceptor may be entered and removed from the tubular chamber. The apparatus further comprises heating means arranged at an outside of the tubular chamber and configured for emitting heat by means of radiation, which heating means are configured for the provision of radiation according to a angularly varying profile within the tubular chamber, which angular heating profile comprises a first and a second angular zone, and wherein a heat flux in the first angular zone is higher than in the second angular zone and wherein the first angular zone includes an area from the top side and/or the bottom side of the chamber. The apparatus further comprises a controller for controlling a state inside the chamber, including temperature and composition.
The heating means comprises a first heating wire of which at least a portion is arranged in the axial direction of the chamber, which first heating wire is provided with a meandering shape such that the first heating wire comprises a plurality of portions extending along the axial direction, which portions are arranged substantially parallel to each other. A mutual distance between a first and a second adjacent portion of the first heating wire is dependent on an angular location of said first and second adjacent portions of the first heating wire, such that the mutual distance is smaller in the first angular zone than in the angular zone.

In a second aspect, the invention provides a system comprising the chemical vapour deposition apparatus of the invention and a susceptor comprising heat-conductive elements.

In a third aspect, the invention provides use of the chemical vapour deposition apparatus and/or the system of the invention for depositing a layer on a substrate carried by a susceptor arranged in the chamber of the chemical vapour deposition apparatus.

It has been found in experiments leading to the invention that heating the chamber in a uniform manner is not desired in certain applications, such as the use of PECVD in combination with susceptors comprising a plurality of conductive plates. It has particularly turned out that the absorption of radiant heat by the conductive plates is dependent on its location. More particularly, the plates facing one of the inner walls of the chamber tend to absorb more heat than those being arranged at an inside of the susceptor. Thus, particularly when limiting the time for heating up, the heat conduction between the plates of the susceptor is slower than the heat radiation and convection to the substrates. The invention addresses this drawback in that the heat radiation is applied in according with a according to a angularly varying profile within the chamber, which angular heating profile comprises a first and a second angular zone, and wherein a heat flux in the first angular zone is higher than in the second angular zone.

In investigations leading to the invention, it has been found that a design of heating wires different from a coil with a plurality of turns is preferred. The use of such a coil is the traditional solution, as is for instance shown in US 4,284,867. The use of a design with wires with portions substantially parallel to the axial direction allows variation of the portions according to an angular profile. Examples of variations include the current through the heating wire, the density of wires or portions thereof, and thus the mutual distance between adjacent wires or portions thereof, the diameter of wires, and the material of the wires. Alternatively or additionally, additional sources of radiation may be provided into the first zone, such as for instance wires and lamps.

In the implementation of the invention, the first heating wire is at least partially provided with a meandering shape such that the first heating wire comprises a plurality of portions extending along the axial direction. It is an advantage hereof that the number of wires can be limited. Furthermore, assembly of a limited number of heating wires with a meander shape is deemed easier than the assembly of a plurality of substantially straight heating wires. The meander shape particularly allows a design wherein a mutual distance between a first and a second adjacent portion - i.e. that are arranged substantially parallel to each other - is dependent on the angular zone. In the first angular zone, the mutual distance is smaller than in the second angular zone.

The background of the heating resides in the different absorption of heat and infrared radiation. The wafers itself on current solar cells, with limited thickness of for instance less than 100 microns, turn out to be transmissive for infrared radiation. This is in contrast to the plates of the wafer boat. Thus, the heat will be absorbed by the wafer boat that heats up. The heat thereafter flows to the wafers by means of heat conduction.

The first zone is herein more particularly arranged so that radiation enters the chamber in a direction substantially parallel to the plates. The second zone is herein more particularly arranged so that radiation enters the chamber in a direction substantially perpendicular to the plates. The term 'substantially parallel' is herein used to indicate an orientation between -45° and +45°, preferably between -30° and +30°. The term 'substantially perpendicular' is herein used to indicate an orientation between 45° and 135°, or even between 60° and 120°.
An additional advantage of the apparatus and system of the invention is limitation of temperature related stress in the materials in the wafer boat. Such temperature related stress may lead to wear and eventually breakage of for instance the plates or the rods of the boat. The limitation of the stress therewith increases lifetime of the wafer boat.

In one embodiment, the heat flux in the first zone may be uniform, and/or the heat flux in the second zone may be uniform, independent on the exact orientation relative to the plates. In this embodiment, it appears preferred that the second zone, with a comparatively low level of emitted radiation even extends further than the first zone, for instance in a range of angles between 30° and 150° relative to the orientation of the plates of the susceptor. In an alternative embodiment, the heat flux may decrease gradually. In a further implementation hereof, it may well be that the gradual decrease of the heat flux occurs in a third zone that is present between the first zone and the second zone. For instance, in such an embodiment, the first zone extends between -20° and +20°, the third zone between +20° and +70° and the second zone between +70° and +110°. Herein all the orientations are indicated relative to the orientation of the plates in the susceptor, that is suitably arranged vertical. While not explicitly specified, it is to be understood that these orientations can be repeated so as to obtain a subdivision of the space in first, second and any third zones (and optionally even further zones).

The tubular reactor of the invention is of the horizontal type as known per se to the skilled person. These are most commonly used in the manufacture of solar cells and a susceptor enters the chamber via a door arranged in a sidewall, and the axial direction being the horizontal direction, or at least being arranged substantially horizontal.
Heating wires with a meander shape may extend circumferential to the chamber, but alternatively would extend partially around the chamber. For instance, in one implementation a first heating wire is used in the first angular zone and a second heating wire is used in the angular radial zone. In its entirety, there may then be at least four heating wires around the circumference. However, it is further feasible to use a first and a second heating wire, each heating wire covering a first and a second angular zone, and particularly in such a configuration that the dissipation and resulting heat flux per unit length of the heating wire in the first angular zone is higher than that in the second angular zone.

Furthermore, a single heating wire may extend along the axial direction from the first to the opposed second end of the chamber. Alternatively and preferably, a plurality of heating wires is present adjacent to each other along the axial direction, for instance 2-10, more preferably 3-6 heating wires. The latter option further allows to create and/or to maintain uniformity in temperature along the axial direction. More particularly, the controller is configured for defining currents through the individual heating wires, based on input from one or more sensors. One further advantage of the use of a plurality of heating wires with a meander shape and arranged behind each other in the axial direction, is that supplementary heating wires may be present. Such supplementary heating wires may be used in case that an initial heating wire would deteriorate due to material degradation. Alternatively or additionally, a programme may be set up so as to balance the use of all heating wires over a period of time. The advantage of the presence of supplementary wires in combination with the meander shape, is that a first wire and a second (supplementary) wire may be arranged such that they may have an overlap in the axial direction, i.e. a tip of a portion of the second wire may be present between a first and a second portion of the first wire, when seen at an axial location. This could be the same for the second wire and a third wire. Therewith, uniformity in heating in the axial direction can be obtained, even though not all heating wires are used as the same time.

Preferably, the angular profile is such that a ratio of heat flux in the first angular zone and the second angular zone is at least 1.5, and more preferably at least 2, such as from 2-4. This ratio has found to give an appropriate heat distribution when the plates are thermally conductive.

The invention is particularly relevant for the deposition of PECVD layers, such as silicon nitride layers. A silicon nitride layer PECVD deposition typically occurs at a temperature of 420-480 degrees. After the deposition, the wafer boat with the wafers leaves the deposition apparatus, and the temperature in the chamber reduces to approximately 350 °C. There is thus a need for heating up for about 100°C. In some applications, the deposition temperature is around 550°C, requiring a heating up of about 200°C. This heating up is preferably carried out in a duration of at most 15 minutes, preferably in the order of 8-12 minutes, or even less. This results in a heating speed of 10-25 degrees per minute. This heating up will mostly be achieved by heat absorption of the plates of the wafer boat and subsequent heat conduction to the individual wafers. In order to achieve that all wafers have the same temperature at the end of the heating up period, it was found that an angular heat profile is highly desired for a horizontal chamber that is provided with a plurality of meander-shaped heating wires arranged in axial direction of the chamber. The meanders of each meander-shaped heating wires are run therein substantially parallel to the axial direction of the chamber. The said longitudinal portions of the heating wires (that make up the meanders) particularly have a length that is for instance at least 5%, more preferably at least 10% of the length of the chamber in axial direction. In this manner, a total deposition time of the layer is reduced with 80% without reducing the deposition quality of the PECVD layer.

### BRIEF DESCRIPTION OF THE FIGURES

These and other aspects of the invention will be further elucidated with reference to the figures, wherein:
Fig. 1 is a bird's eye perspective of a first embodiment of the system of the invention with a chemical vapour deposition apparatus and a susceptor;
Fig. 2 shows a susceptor in more detail; and
Fig. 3 is a front view of the chamber of the apparatus with the susceptor therein.

### DETAILED DESCRIPTION OF ILLUSTRATED EMBODIMENTS

The figures are not drawn to scale and merely diagrammatical in nature. Equal reference numerals in different figures refer to equal or corresponding parts.

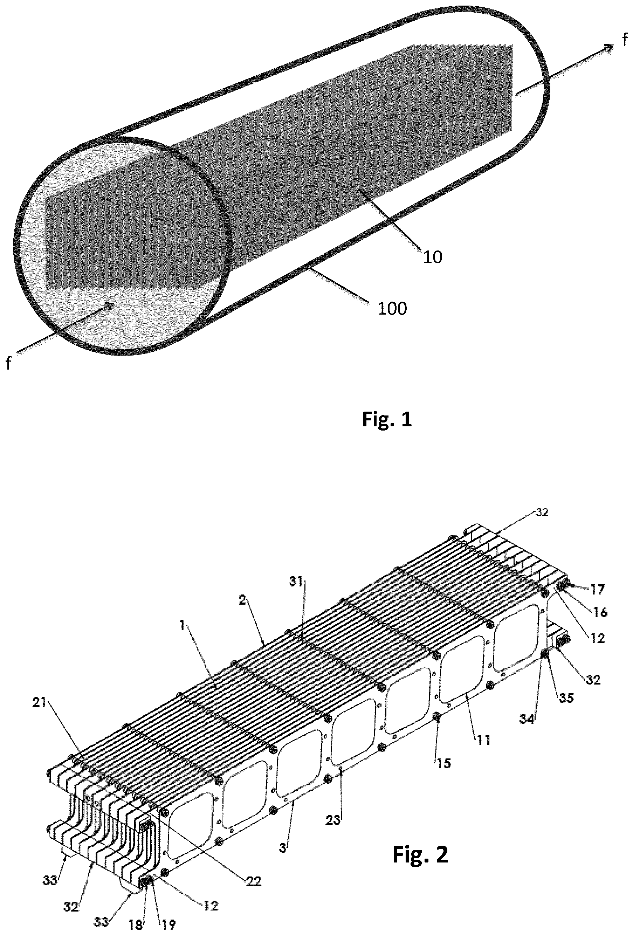

Figure 1 shows in a bird's eye perspective a first embodiment of the system of the invention. Shown herein is a tubular chamber 100 of a chemical vapour deposition apparatus and a susceptor 10. For sake of clarity, further details of the chamber 100 and the apparatus are omitted. Likewise, the susceptor 10 is shown in simplified manner in that merely the conductive plates thereof are shown. A more detailed view of the susceptor is shown in Fig. 2.

The tubular chamber 100 of the present embodiment is a tubular reactor of the horizontal type. The chamber 100 is typically provided with an entrance through which a susceptor (hereinafter called wafer boat) may be entered and omitted into the chamber. In Fig. 1, this entrance would be located at the end of the chamber shown at the left hand side. The chamber 100 is in this embodiment tubular, having a cylindrical cross-section. This is preferred and conventional though other shapes, for instance with an oval cross-section, are not excluded. The chamber has a length direction, which is indicated in Figure 1 with the arrows f. In this embodiment, the length direction is the axial direction. It is visible that the parallel plates of the wafer boat are herein oriented along the length direction f. While the tubular chamber preferably has a single standard diameter, and a circular cross-section, it is not excluded that the cross-sectional shape of the tubular chamber deviates from truly circular, and is oval, or would be octagonal or the like.

The chamber 100 is typically provided with at least one inlet for a compound in the vapour phase. The compounds are typically precursor compounds for deposition of films containing silicon, oxygen, nitrogen, titanium and the like, or non-reactive gases such as argon. Typically, an inlet is specific for a compound. One or more outlets for unused gases are also foreseen, for instance coupled to a pump. The chamber is further provided with a mounting means onto which the susceptor can be placed. The chamber may be further provided with one or more sensors, such as a temperature sensor and a pressure sensor, as is well known to the skilled person.

More particularly, the deposition apparatus of this embodiment is suitably provided with means for generating a plasma, such as a low frequency plasma generator as known per se. The wafer boat can be coupled to the plasma generator by means of contact pads. Upon mounting the wafer boat in the chamber, contacts on the boat will get into physical contact with said contact pads. The plasma-enhanced deposition process typically is carried out at a pressure in the range of 0 and 10 Torr, at a temperature in the range of 250-600°C.

Fig. 2 shows in more detail a first embodiment of a wafer boat suitable for a plasma-enhanced chemical vapour deposition process, and particularly designed for semiconductor substrates to be processed into solar cells. The wafer boat comprises a plurality of first plates 11 and second plates 21, which are spaced apart by means of spacers 31. Typically the total number of plates 11, 21 is between 15 and 30, for instance from 19 to 26. The plates 11, 21 are made of an electrically conducting material, typically graphite. The plates are provided with holes 13. In the present embodiment there are seven holes 13 in a row. The plates 11, 21 comprise holes 13 close to their upper sides 2 and close to their bottom sides 3. Electrically insulating rods 15 are present to pass the holes 13 and the spacers 31, which are also provided with holes. The rods have a first end A and an opposed second end B. In order to fixate the rods 15, a nut 34 and a securing nut 35 are present at their ends A, B. As is known to the skilled person, the plates 11, 21 are typically provided with windows. Such window is however closed in the outermost plate 11. Extensions 12, 22 extend from the first plate 11 and the second plate 21 respectively. The first extensions 12 to the first plate 11 are in this view located at the upper side 1 and the second extensions 22 to the second plate 21 are in this view located at the bottom side 3. As a consequence, a separation is achieved between the first and second extensions 12, 22. The first plates 11 may thus be electrically connected with each other by means of the first extensions 12 and conductive spacers 32. Similarly, the second plates 12 may be electrically connected by means of the second connections 22 and conductive spacers. In this manner, a pattern of interdigitated, mutually spaced electrodes is formed. A voltage difference may be applied between the electrodes, i.e. the first and second plates 11, 21. This is deemed a particularly useful method for generating a plasma around the substrates (also known as wafers) to be positioned in the boat between a first and an adjacent second plate. The spacers 32 are connected to the first extensions 12 with first rod 16 and auxiliary rod 17. Further spacers are connected to the second extensions 22 with second rod 18 and auxiliary rod 19. In this embodiment, the first and second rod 16, 17 are electrically conductive and the auxiliary rods 18, 19 are electrically insulating. This is deemed suitable, but not essential. The boat is supported by a support element 33 that extends from said conductive spacers at the bottom side 3. It will be understood that the design of the shown wafer boat is not intended to be limiting and may be varied.

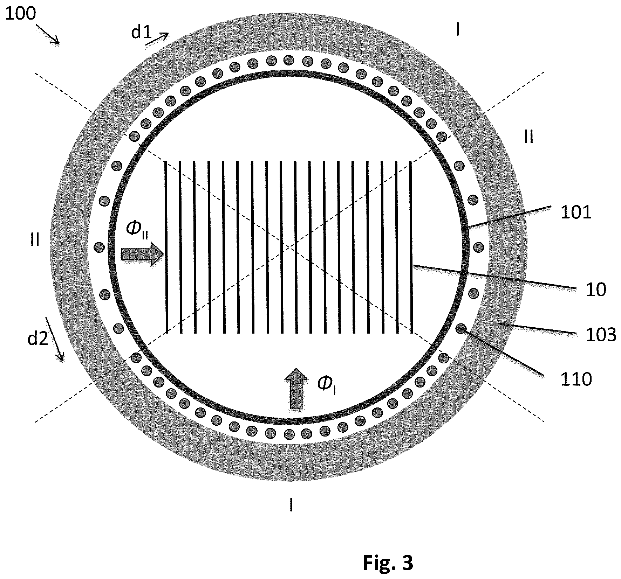

Fig. 3 shows a diagrammatical side view of the chamber 100 with a wafer boat 10 inserted therein. The chamber 100 comprises an inner wall 101, typically made of quartz or silicon carbide, around which one or more heating wires 110 are present. The heating wires are enclosed by an outer wall 103. The outer wall 103 may contain a heat reflector so as to increase the efficiency. The outer wall 103 may further be provided with cooling means. The wafer boat 10 is suitably heated by means of radiation entering the chamber 100 from the one or more heating wires 110. Such heating may continue during the deposition process. Prior to the start of the deposition process, the wafer boat may further be heated by convection of carrier gas in the chamber. The wafer boat 10 may further be heated by heat conduction from a heat element with which the wafer boat 10 is in contact and by the plasma exposure to the boat. A controller of the vapour deposition apparatus is configured for controlling the heating process.

In investigations leading to the invention, wherein use was made of fast ramp-up heating of the graphite wafer boat 10, it was observed that outer plates of the wafer boat 10 are heated up to a higher temperature than inner plates. The outer plates are those directly at a side of the wafer boat 10, but some plates adjacent thereto, overall for instance the outer 1-4 plates on each side. As a consequence, a layer thickness of a deposited layer on a substrate may be dependent on a location of the substrate within the wafer boat 10. It was more particularly found that layer thicknesses that are deposited on a substrate located adjacent to an outer plate of the wafer boat 10 are larger than those deposited on a substrate located adjacent to an inner plate of the wafer boat 10. For sake of clarity, fast ramp-up heating is understood to refer to a heating period of at most 30 minutes. Preferably, the fast ramp-up is carried out in a period of at most 15 minutes. The current invention also allowed to apply such an ultrafast ramp-up period.

According to the invention, therefore, an angular profile is applied, such that the heat flux *Φ*_{I} in a first angular zone I is higher than the heat flux *Φ_{II}* in a second angular zone II. For sake of clarity, the heat flux is herein defined per m². In one implementation, as illustrated in Figure 3, this difference in heat flux, and more particularly in emitted radiation, is based on a density of heating wire portions 110 extending in the axial direction f. The density of heating wires 110 in the first angular zone I is then higher than in the second angular zone II. In other words, the mutual distance d1 between a first and a second heating wire portion in the first angular zone I is smaller than the corresponding mutual distance d2 in the second angular zone II. In the illustrated embodiment, the first angular zone is limited by angles of -55° and +55°, relative to the orientation of the plates. The second angular zone II is limited by angles of 55° and 125°. This is however merely an example and modifications of the angular extensions of the first and the second angular zone are feasible. It is further feasible to introduce any intermediate third angular zone between the first and the second angular zones with an intermediate heat flux. It will be further appreciated that the shape and size of the wafer boat 10 may have an impact on the extension of the angular zones. The improved uniformity in layer thickness is deemed particularly relevant for layer growth of for instance silicon nitride, silicon oxide, silicon carbide, aluminium oxide or a combination of these materials.

## Claims

1. A chemical vapour deposition apparatus comprising:
- a tubular chamber of a horizontal type and provided with a bottom side and a top side and an axial direction, which tubular chamber is configured for arrangement of a susceptor carrying a plurality of substrates along the axial direction, which tubular chamber is provided with at least one inlet for a compound in a vapour phase into the tubular chamber and with an entrance through which the susceptor may be entered and removed from the tubular chamber, said axial direction being substantially parallel to a direction along which a susceptor is entered into and removed from the chamber;
- heating means arranged at an outside of the tubular chamber and configured for emitting heat by means of radiation, which heating means are configured for the provision of radiation according to a angularly varying profile within the tubular chamber, which angular heating profile comprises a first and a second angular zone, and wherein a heat flux in the first angular zone is higher than in the second angular zone and wherein the first angular zone includes an area from the top side and/or the bottom side of the chamber, and
- a controller for controlling a state inside the chamber, including temperature and composition,
wherein the heating means comprises a first heating wire of which at least a portion is arranged in the axial direction of the chamber, which first heating wire is provided with a meandering shape such that the first heating wire comprises a plurality of portions extending along the axial direction, which portions are arranged substantially parallel to each other,
wherein a mutual distance between a first and a second adjacent portion of the first heating wire is dependent on an angular location of said first and second adjacent portions of the first heating wire, such that the mutual distance is smaller in the first angular zone than in the angular zone.

2. The chemical vapour deposition apparatus as claimed in Claim 1, wherein the first angular zone is configured for providing radiation in a direction substantially parallel to conductive plates of the susceptor.

3. The chemical vapour deposition apparatus as claimed in claim 1, wherein the first heating wire extends substantially circumferentially to the tubular chamber.

4. The chemical vapour deposition apparatus as claimed in any of the preceding claims 1-3, wherein a second heating wire is present that comprises a meander shape and that is displaced relative to the first heating wire along the axial direction.

5. The chemical vapour deposition apparatus as claimed in claim 4, wherein the number of heating wires present adjacent to each other along the axial direction is in the range of 2-10.

6. The chemical vapour deposition apparatus as claimed in any of the claims 4-5, wherein the controller is configured for defining currents through the individual heating wires, based on input from one or more sensors.

7. The chemical vapour deposition apparatus as claimed in claim 4-6, wherein a supplementary heating wire is present, which supplementary heating wire comprises a meander shape and is arranged between the first and the second heating wire along the axial direction, wherein the first and the supplementary heating wire are arranged such that they have an overlap in the axial direction.

8. The chemical vapour deposition apparatus as claimed in claim 7, wherein a tip of a portion of the second heating wire is present between a first and a second portion of the first heating wire, when seen at an angular location.

9. The chemical vapour deposition apparatus as claimed in claim 7-8, wherein the supplementary heating wire and the second heating wire are arranged such that they have an overlap in the axial direction.

10. The chemical vapour deposition apparatus as claimed in claim 7-9, wherein the controller is provided with a programme for balancing the use of all heating wires over a period of time.

11. The chemical vapour deposition apparatus as claimed in any of the preceding claims, wherein the angular profile is such that a ratio of heat flux in the first angular zone and the second angular zone is at least 1.5, preferably at least 2, for instance 2-4.

12. The chemical vapour deposition apparatus as claimed in any of the preceding claims, further comprising means for generating a plasma inside the chamber, and wherein preferably the controller and the heating wires are configured for ramping up a temperature in the tubular chamber from a handling temperature to a deposition temperature within 15 minutes.

13. A system comprising the chemical vapour deposition apparatus as claimed in any of the preceding claims and a susceptor comprising heat-conductive elements, wherein the heat-conductive elements of the susceptor are preferably plates that extend, after insertion of the susceptor into the chamber, along the axial direction of the chamber.

14. The system as claimed in Claim 13, wherein the apparatus comprises means for generating a plasma inside the chamber and the susceptor comprises a first and a second set of plates that are arranged alternatingly and in use operate as first and second electrodes.

15. Use of the chemical vapour deposition apparatus and/or the system as claimed in any of the preceding claims for depositing a layer on a substrate carried by a susceptor arranged in the chamber of the chemical vapour deposition apparatus, wherein the layer deposition is preferably part of the manufacture of a solar cell.
